# EUROPEAN PATENT APPLICATION

(11) **EP 2 249 395 A1**
(43) Date of publication of application: **10.11.2010**
(21) Application number: 09715527.9
(22) Date of filing: 17.02.2009
(51) Int. Cl.: H01L 31/04, H01L 31/042

(54) **THIN FILM SOLAR BATTERY AND METHOD FOR MANUFACTURING THE SAME**

(30) Priority: 27.02.2008 JP 2008046640
(71) Applicant: Sharp Kabushiki Kaisha, Osaka-shi, Osaka 545-8522 (JP)
(72) Inventor: TACHIBANA, Shinsuke, Osaka-shi, Osaka 545-8522 (JP)
(74) Representative: Müller - Hoffmann & Partner
(86) International application number: PCT/JP2009/052686
(87) International publication number: WO 2009/107517

(57) **Abstract**

A method for manufacturing a thin film solar cell is **characterized by** including a string formation step for forming a string of thin film photoelectric conversion elements which are electrically connected in series and each of which has a first electrode layer, a photoelectric conversion layer and a second electrode layer which are successively laminated on a surface of a translucent insulation substrate; a film removal step for removing the thin film photoelectric conversion element portion formed on the outer circumference of the surface of the translucent insulation substrate by a light beam to form a non-conductive surface region on the entire circumference; and a cleaning step for removing conductive extraneous matters generated in the film removal step and attached to the non-conductive surface region.

## Description

### TECHNICAL FIELD

The present invention relates to a thin film solar cell with a dielectric withstand voltage of high reliability, and to a method for manufacturing such a thin film solar cell.

### BACKGROUND ART

Conventionally, for example, Patent Document 1 discloses a thin film solar cell comprising a string of thin film photoelectric conversion elements which are electrically connected each other in series and each of which has a transparent electrode layer, a photoelectric conversion layer and a metal electrode layer which are successively layered on the surface of a translucent insulation substrate. This thin film solar cell is structured so that the entire surface of the translucent insulation substrate including the string is sealed with a resin layer and a protective film.

Since such a thin film solar cell is positioned at a position with being framed by a metal frame around its circumference, a dielectric withstand voltage is needed in order not to be broken by a thunderbolt to the metal frame.
The thin film solar cell of Patent Document 1 has an insulation separation line of 0.5 mm - 1 cm in width which is positioned in a predetermined distance inside the outer circumferential end faces of the translucent insulation substrate. This insulation separation line is formed by removing the transparent electrode layer, the photoelectric conversion layer and the metal electrode layer (may be referred to as "conductive films" altogether hereinafter), so that the insulation separation line assures the necessary dielectric withstand voltage. To make the insulation separation line, it is suggested that the conductive films are removed by laser light, using a grind machine or spray of fine particles.
Patent Document 1: Japanese Unexamined Patent Application Publication No. 2000-261019

### DISCLOSURE OF THE INVENTION

### PROBLEMS TO BE SOLVED BY THE INVENTION

However, when a mechanical method for removing the conductive films such as a grinding method using the grind machine or a blasting method for spraying the fine particles is used, the translucent insulation substrate may be damaged due to the mechanical method for removing the conductive films, so that it is not any suitable method. Further, after such a method, grinding dusts, abrasive grains or the fine particles may be attached to the surface of the string, so that it is necessary to clean them with water. In addition, the water used for the water-cleaning must be treated, thereby increasing the manufacturing steps and cost.
It may be possible to remove the conductive films by chemical etching in place of the mechanical method for removing the conductive films. In such a wet process, however, the density of a liquid medicine, the temperature thereof and the like must be controlled in addition to the addition of the cleaning step, so that a processing device may become complicated to increase the cost, which is not preferable.

Incidentally, the present inventors experiment to evaluate a dielectric withstand voltage by an insulation test machine before the thin film solar cell is sealed whose conductive films are removed by laser machining. It is found that insulation failure may be caused. Analysis of this insulation failure reveals that conductive processing dusts caused by the laser machining or the burnt substances of conductive processing dusts may be attached to the surface of the exposed translucent insulation substrate on the insulation separation line to cause the insulation failure. When a higher testing withstand voltage is applied with increasing a system voltage to the thin film solar cell, the problems of the insulation failure are more outstanding.

In order to solve the problems in the conventional techniques, an object of the present invention is to provide a thin film solar cell of high reliability for securing a necessary dielectric withstand voltage by a simplified method, and to provide a method for manufacturing such a thin film solar cell.

### MEANS FOR SOLVING THE PROBLEMS

Therefore, according to the present invention, a method for manufacturing a thin film solar cell is provided which includes a string formation step for forming a string of thin film photoelectric conversion elements which are electrically connected in series and each of which has a first electrode layer, a photoelectric conversion layer and a second electrode layer which are successively laminated on a surface of a translucent insulation substrate; a film removal step for removing the thin film photoelectric conversion element portion formed on the outer circumference of the surface of the translucent insulation substrate by a light beam to form a non-conductive surface region on the entire circumference; and a cleaning step for removing conductive extraneous matters generated in the film removal step and attached to the non-conductive surface region.

According to another aspect of the present invention, a thin film solar cell manufactured by the manufacturing method is provided comprising the string formed on the surface of the translucent insulation substrate and the non-conductive surface region formed on the outer circumference of the surface of the translucent insulation substrate, wherein the non-conductive surface region is formed in a predetermined width or more in compliance with a system voltage from the outer circumference end face of the translucent insulation substrate to an inward of a plane direction.

According to the present invention, in the film removal step to form the non-conductive surface region, even if the first electrode layer, the photoelectric conversion layer and the second electrode layer each removed by the light beam may be attached to the non-conductive surface region as the conductive extraneous matters, they can be securely removed therefrom by cleaning the non-conductive surface region. As a result, a thin film solar cell with a dielectric withstand voltage of improved reliability can be obtained at a high yield.

### BRIEF DESCRIPTION OF THE DRAWINGS

Fig. 1 is a plan view illustrating a thin film solar cell in accordance with an embodiment 1 of the present invention.
Fig. 2 is a sectional view taken on line of A-A in Fig. 1.
Fig. 3 is a sectional view taken on line of B-B in Fig. 1.
Fig. 4 is a plan view illustrating a thin film solar cell in accordance with an embodiment 2 of the present invention.
Fig. 5 is a sectional view taken on line of C-C in Fig. 4.

### DESCRIPTION OF THE REFERENCE NUMERALS

1: translucent insulation substrate
2, 12: first electrode layer
3, 13: photoelectric conversion layer
4, 14: second electrode layer
5, 15: thin film photoelectric conversion element
8: non-conductive surface region
9: solder member
10: bus bar
17: adhesive layer
18: rear-side sealing member
20: insulation separation line
S1, S2: string

### BEST MODE FOR CARRYING OUT THE INVENTION

A method for manufacturing a thin film solar cell according to the present invention is **characterized in that** it includes a string formation step for forming a string of thin film photoelectric conversion elements which are electrically connected in series and each of which has a first electrode layer, a photoelectric conversion layer and a second electrode layer which are successively laminated on a surface of a translucent insulation substrate; a film removal step for removing the thin film photoelectric conversion element portion formed on the outer circumference of the surface of the translucent insulation substrate by a light beam and forming a non-conductive surface region on the entire circumference; and a cleaning step for removing conductive extraneous matters generated in the film removal step and attached to the non-conductive surface region.

In the present invention, the conductive extraneous matters include at least either the conductive processing dusts which are generated in the film removal step by removing a thin film photoelectric conversion element portion (the conductive films composed of the first electrode layer, the photoelectric conversion layer and the second electrode layer) formed on the outer circumference of the surface of the translucent insulation substrate by the light beam irradiation and which are attached to the non-conductive surface region, or the conductive burnt substances of the conductive processing dusts burnt by the light beam on the non-conductive surface region.
Herein, the thin film photoelectric conversion element portion may be referred to a "cell" and the thin film photoelectric conversion element portion to be removed may be referred to the "conductive films".

When the conductive extraneous matters are attached to the non-conductive surface region, a dielectric withstand voltage necessary for a thin film solar cell may not be obtained, and the thin film solar cell may become in failure due to a thunderbolt to the thin film solar cell itself or a metal frame attached around the outer circumference of the thin film solar cell.
According to the present invention, the conductive extraneous matters attached to the non-conductive surface region are removed and cleaned, a thin film solar cell with a necessary withstand voltage can be manufactured at a high yield. In particular, the formation of the non-conductive surface region by the light beam irradiation is performed by making a plurality of grooves, while moving the light beam irradiation in parallel, in which step it is difficult to avoid generating the conductive extraneous matters as mentioned above. According to the present invention, the cleaning step is provided which removes securely the conductive extraneous matters.

Herein, the dielectric withstand voltage is defined as a performance that no discharge is caused between a thin film solar cell and a frame attached around the outer circumference of the thin film solar cell, even when a predetermined high voltage is applied between the thin film solar cell and the frame. The dielectric withstand voltage can be checked by a withstand voltage test defined by e.g., an International Standard (IEC: Nos. 61730 and 61646). In the case of a thin film solar cell module whose system voltage is 1000 V, the International Standard requires a dielectric withstand voltage against a lightning surge withstand voltage of 6 KV.

According to the present invention, a check step may be included to check whether the thin film solar cell after a wiping step has a necessary dielectric withstand voltage or not. This check step is conducted per sheet of the thin film solar cell in which a predetermined voltage is applied to the outer circumference end face of the surface of the translucent insulation substrate under the condition that the second electrode layer is grounded. When a resistance at this time is a predetermined value or more (or a current is a predetermined value or less), the test is determined as a passing. This applied voltage is set dependent upon the value of the system voltage for the thin film solar cell. For example, when the system voltage for the thin film solar cell is 1000 V, the applied voltage is 6000 V in which the passing is determined if the current is less than 50 µA.

In the present invention, the cleaning step may be performed by an operator (man power) or mechanically. Anyway, it is desirable to presume that it may be possibly caused that the conductive extraneous matters attached to the non-conductive surface region cannot be completely removed and may still remain, whereby a resistance may be less than a predetermined value in the check step.

For this reason, according to the present invention, when a resistance is less than a predetermined value (or a current is more than a predetermined value) in the first check step, the cleaning step and the check step may be repeated once or more in this order. Then, a failure that a resistance is less than a predetermined value due to the residue of the extraneous matters can be hardly caused. The reliability of a dielectric withstand voltage needed by the thin film solar cell can be highly increased and the yield can become close to 100 %.

Moreover, some thin film solar cells of insulation failure may be possibly derived from the reasons why the conductive burnt substances cannot be removed and it is difficult to remove them, or the conductive films cannot be completely removed and may still remain. Therefore, a visual check or the like can be performed to specify positions of insulation failure on the surface of the non-conductive surface region. Only the positions of the insulation failure can be mechanically grounded to create insulation processing. The check step for checking the insulation performance can be performed once again to assure its passing grade, so that it becomes unnecessary to destroy some thin film solar cells.

In the present invention, as long as the cleaning step can remove the conductive extraneous matters on the non-conductive surface region without damaging the thin film solar cell, the cleaning step is not limited to any particular means.
Specifically, it may include a wiping method using a wiping material, the conductive extraneous matters on the non-conductive surface region, a method for jetting air to blow off the conductive extraneous matters on the non-conductive surface region, a method for sucking the conductive extraneous matters on the non-conductive surface region with air, or the like. These methods may be used in combination. Among these methods, it is preferable that at least the cleaning method with the wiping material is included in view of effectively removing the conductive burnt substances, which removal is more difficult than that of the conductive processing dusts.

According to the present invention, the wiping material may be such that an organic solvent is absorbed into a wiping base member which does not damage the translucent insulation substrate and the second electrode layer, or the like outside exposed during the wiping step. The conductive burnt substances (extraneous matters) burnt on the non-conductive surface region can be removed from the non-conductive surface region by a physical action of friction with the wiping base member, and can be wiped by the wiping base member wet by the organic solvent without being attached thereto again.
It is preferable that such a wiping base member is a cloth, a nonwoven fabric or a sponge.
Moreover, it is preferable that the organic solvent is highly volatile and can be volatilized from the non-conductive surface region immediately after the wiping step such as, for example, ethanol, acetone, or the like. The use of the organic solvent of highly volatile type enables the organic solvent to scarcely remain on the wiped non-conductive surface region, thereby increasing further the reliability for the check at the next check step.

The thin film solar cell manufactured by the manufacturing method comprises the string formed on the surface of the translucent insulation substrate and the non-conductive surface region formed on the outer circumference of the surface of the translucent insulation substrate, wherein the non-conductive surface region is formed in a predetermined width or more in compliance with a system voltage from the outer circumference end face of the translucent insulation substrate to an inward of a plane direction.
It is defined by the International Standard (IEC: Nos. 61730 and 61646) that the width of the non-conductive surface region is needed to be 6.4 mm or more when the system voltage of the thin film solar cell is 301 to 600 V, and 8.4 mm or more when the system voltage of the thin film solar cell is 601 to 1000 V.

Incidentally, while forming the non-conductive surface region, some conductive extraneous matters may be adhered to or burnt on end faces of the respective thin film photoelectric conversion elements adjacent to the non-conductive surface region, and if they remain without being able to be wiped, the first electrode layer and the second electrode layer may be short-circuited by the conductive extraneous matters and the cell cannot generate electric power. Otherwise, the power generation cell may be broken by the operation of the wiping step. In this case, particular cells which may not generate electric power by short circuit among a plurality of cells are ones other than the cells positioned at the ends in a direction that the cells are connected in series. Besides, a cell positioned at a current-output side among the cells positioned at the ends in the direction that the cells are connected in series does not contribute to any power generation.

Therefore, according to the present invention, an insulation separation line of about 10 to 300 µm in width may be further formed by removing the thin film photoelectric conversion element portion (the conductive films comprising the first electrode layer, the photoelectric conversion layer and the second electrode layer) in a distance of 0.5 to 10 mm inwardly from an interface between the non-conductive surface region and the string which are positioned in a direction orthogonal to serial connecting direction of the thin film photoelectric conversion elements.
The formation of the insulation separation line enables the insulation separation of the end faces adjacent to the non-conductive surface region of the respective cells other than the cells positioned at the ends in a direction that the cells are connected in series, and thereby short-circuiting the respective cells can be prevented.
In the present invention, the string is referred to being inclusive of portions separated by the insulation separation line.
Hereinafter, the thin film solar cell and the manufacturing method according to the present invention will be specifically described with reference to the drawings.

### (Embodiment 1)

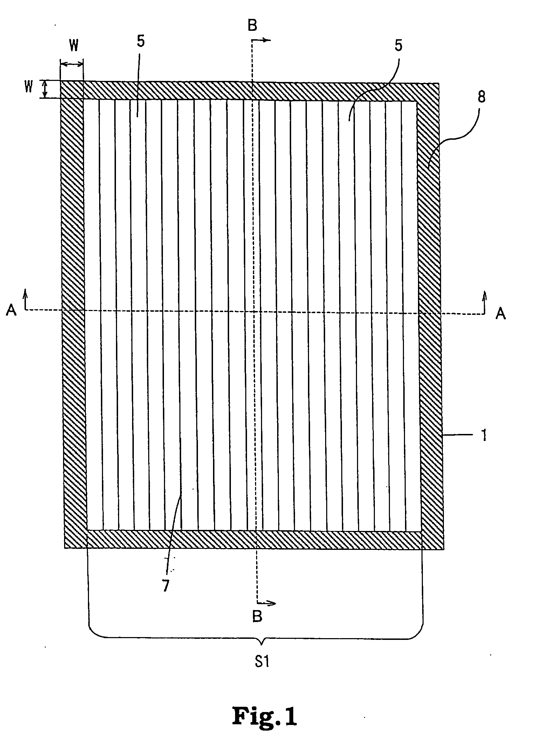

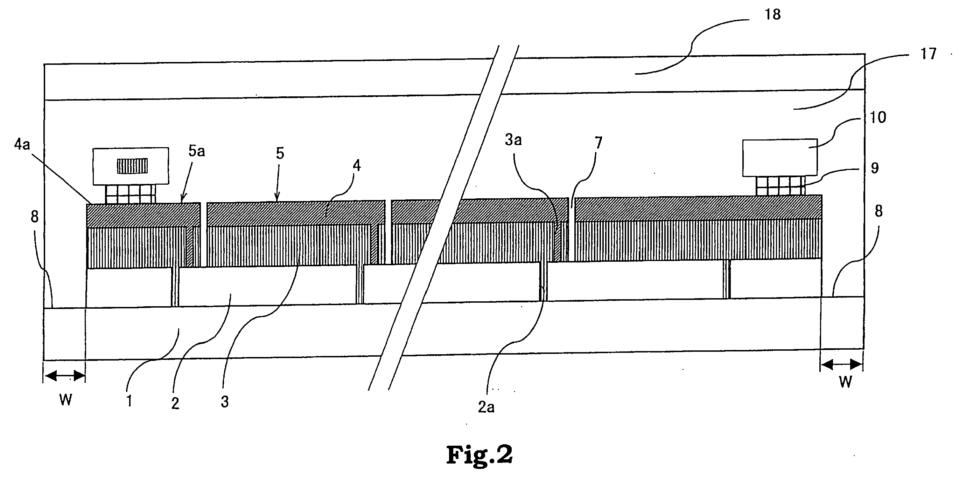

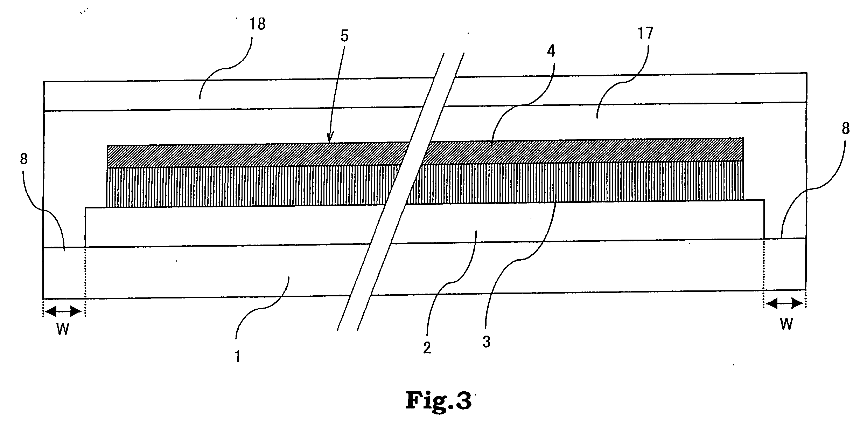

Fig. 1 is a plan view illustrating a thin film solar cell in accordance with an embodiment 1 of the present invention. Fig. 2 is a sectional view taken on line of A-A in Fig. 1. Fig. 3 is a sectional view taken on line of B-B in Fig. 1.
The thin film solar cell is of a super straight type comprising a rectangular translucent insulation substrate 1 and a string S1 of thin film photoelectric conversion elements 5 which are electrically connected in series and each of which has a first electrode layer 2, a photoelectric conversion layer 3 and a second electrode layer 4 which are successively layered on a surface of the translucent insulation substrate 1.

### [Translucent insulation substrate and first electrode layer]

A glass substrate, a resin substrate such as polyimide or the like may be used as the translucent insulation substrate 1, the glass substrate and the resin substrate having heat resistance and translucency for the subsequent film formation step.
The first electrode layer 2 is made of a transparent conductive film, preferably, composed of a material including ZnO or SnO₂. The material including SnO₂ may be SnO₂ itself or a mixture of SnO₂ and another oxide (e.g., ITO being a mixture of SnO₂ and In₂O₃).

### [Photoelectric conversion layer]

The material of semiconductor layers making up the photoelectric conversion layer 3 is not limited to any specific one and may be, for example, a silicon-based semiconductor, CIS (CuInSe₂) compound semiconductor, CIGS (Cu(In, Ga)Se₂) compound semiconductor or the like. Hereinafter, an example in the case of the silicon-based semiconductor is exemplified. The "silicon-based semiconductor" means a semiconductor (silicon carbide, silicon germanium or the like) made of amorphous or microcrystalline silicon, or amorphous or microcrystalline silicon doped with carbon, germanium or other impurities. The term "microcrystalline silicon" means silicone of mixed phase state of crystalline silicon having small crystal particle size (about several tens to thousand angstroms), and amorphous silicon. The microcrystalline silicon is formed, for example, when a crystalline silicon thin film is formed at a low temperature using a non-equilibrated process such as a plasma CVD method.

The photoelectric conversion layer 3 comprises a p-type semiconductor layer, an i-type semiconductor layer and an n-type semiconductor layer laminated in turn from the side of the first electrode layer 2.
P-type impurity atoms such as boron, aluminum or the like are doped into the p-type semiconductor layer, and n-type impurity atoms such as phosphorous or the like are doped into the n-type semiconductor layer. The i-type semiconductor layer may be perfectly non-doped semiconductor layer, or may be of a weak p-type or weak n-type semiconductor layer containing a small amount of impurities, having a sufficient photoelectric conversion function. Here in the present specification, the "amorphous layer" and the "microcrystalline layer" means an amorphous semiconductor layer and a microcrystalline semiconductor layer, respectively.
The photoelectric conversion layer 3 may comprise a plurality of layered p-i-n structures, called a tandem type. For example, it may comprise an upper semiconductor layer composed of an a-Si:H p-layer, an a-Si:H i-layer and an a-Si:H n-layer layered in this order on the first electrode layer 2 and a lower semiconductor layer composed of a µc-Si:H p-layer, a µc-Si:H i-layer and a µc-Si:H n-layer layered in this order on the upper semiconductor layer. Further, the photoelectric conversion layer 3 may be three-layered of the p-i-n structures comprising an upper semiconductor layer, a middle semiconductor layer and a lower semiconductor layer. For example, the upper semiconductor layer and the middle semiconductor layer may be composed of an amorphous silicon (a-Si) and the lower semiconductor layer may be composed of a microcrystalline silicon (µc-Si) to form the three-layered structures. The combinations of the materials and the laminated structures of the photoelectric conversion layer 3 should not be limited to any particular one. Throughout the embodiments and the examples of the present invention, a semiconductor layer positioned at a light incident side of the thin film solar cell is referred to as an upper semiconductor layer, whereas another semiconductor layer positioned at the side opposed to the light incident side is referred to as a lower semiconductor layer.

### [Second electrode layer]

The structure and the material of the second electrode layer 4 are not limited to a particular one, but as an example the second electrode layer 4 may be a laminated structure comprising a transparent conductive film and a metal film laminated on the photoelectric conversion layer. The transparent conductive film is composed of ZnO, ITO, SnO₂ or the like. The metal film is composed of a metal such as silver, aluminum or the like. Besides, it may be possible that the second electrode layer 4 may be made of only a metal film such as Ag, Al or the like, but, preferably, the transparent conductive film composed of ZnO, ITO, SnO₂ or the like should be further positioned at the side of the photoelectric conversion layer 3 in order to increase a reflection coefficient by reflecting light, not absorbed by the photoelectric conversion layer 3, with a rear electrode layer 4, thereby providing a thin film solar cell of high conversion efficiency.

### [String]

The string S1 includes a plurality of isolation grooves 7 on the surface. In order to electrically isolate the second electrode layer 4 and the photoelectric conversion layer 3 of one of the thin film photoelectric conversion elements 5 from the second electrode layer 4 and the photoelectric conversion layer 3 of the adjacent another of the thin film photoelectric conversion elements 5, the isolation grooves 7 are formed which extend in a direction (a direction of the longitudinal side of the translucent substrate 1) orthogonal to serial connecting direction of the cells. A lamination film 5a composed of the first electrode layer, the photoelectric conversion layer and the second electrode layer positioned in an end in a direction that the cells is connected in series (the leftmost position of Fig. 2) of the string S1 do not substantially contribute to any power generation because the width of the lamination film 5a in a direction that the cells are connected in series is narrowly formed. For this reason, the second electrode layer of the lamination film 5a serves as a extraction electrode 4a for the first electrode layer 2 of the adjacent thin film photoelectric conversion element 5. Further, as shown in Fig. 3, to prevent leakage due to the adherence of the above-mentioned extraneous matters to the end faces of the cells, a photoelectric conversion layer 13 and a second electrode layer 14 longitudinally positioned in the ends of the respective thin film photoelectric conversion elements 5 are inwardly cut than a first electrode layer 12.

The string S1 is formed inside the outer circumference end faces (the rectangular end faces) of the translucent insulation substrate 1. That is, the outer circumference region of the surface of the translucent insulation substrate 1 serves as a non-conductive surface region 8 free of the first electrode layer 2, the photoelectric conversion layer 3 and the second electrode layer 4.
The non-conductive surface region 8 is formed during forming the string S1 by removing the first electrode layer 2, the photoelectric conversion layer 3 and the second electrode layer 4 each existing at the outer circumference of the substrate, and the region 8 is an insulation region formed by removing and cleaning the above-mentioned extraneous matters caused during forming the non-conductive surface region 8. The width W of the non-conductive surface region 8 is set to correspond to the output voltage of the thin film solar cell as mentioned above.

### [Other structures]

On the second electrode layer 4 and the extraction electrode 4a positioned at the ends in a direction that the cells are connected in series in the string S1, longitudinally, a bus bar 10 is electrically connected by a solder member 9 (e.g., a silver paste). A retrieving line (e.g., a cupper wire), not shown, is electrically connected to each of the bus bars 10.
A rear-side sealing member 18 for completely covering the string S1 and the non-conductive surface region 8 is laminated on the translucent insulation substrate 1 via an adhesive layer 17. The adhesive layer 17 may be used as a sealing resin sheet that is made of, for example, an ethylene-vinyl acetate copolymer (EVA). The rear -side sealing member 18 may be used as a laminated film of, for example, PET/aluminium/PET. A small hole for leading out the tip of the respective retrieving lines is preliminarily formed on the adhesive layer 17 and the rear-side sealing member 18.
A terminal box having output lines electrically connected to the retrieving lines and terminals is attached on the rear-side sealing member 18.
A frame (e.g., of aluminum) is framed to the outer circumference of the thin film solar cell sealed by the rear-side sealing member 18 and the adhesive layer 17.

### <Manufacturing method of thin film solar cell>

The above-mentioned thin film solar cell can be manufactured by a manufacturing method at least including a string formation step for forming a string S1 of thin film photoelectric conversion elements 5 which are electrically connected in series and each of which has a first electrode layer 2, a photoelectric conversion layer 3 and a second electrode layer 4 which are successively laminated on a surface of a translucent insulation substrate 1; a film removal step for removing the thin film photoelectric conversion element portion formed on the outer circumference of the surface of the translucent insulation substrate 1 by a light beam to form a non-conductive surface region 8 on the entire circumference; and a cleaning step for removing conductive extraneous matters generated in the film removal step and attached to the non-conductive surface region; and, preferably, including further a check step for checking an insulation performance of the cleaned non-conductive surface region 8.

### [String formation step]

In the string formation step, a transparent conductive film of 600 to 1000 nm in thickness is formed over the entire surface of the translucent insulation substrate 1 by a method such as CVD, sputtering, evaporation or the like. The transparent conductive film is partially removed by the light beam to form isolation lines 2a, so that the first electrode layers 2 with a predetermined pattern are formed. At this time, a fundamental wave (wavelength: 1064 nm) of YAG laser is irradiated from a side of the translucent insulation substrate 1 to separate the transparent conductive film in a predetermined width in a strip manner, so that the isolation lines 2a are formed at a predetermined interval. In Fig. 2, the first electrode layer 2 at the leftmost position is prevented from functioning as a cell and is narrow in width.

Then, a resulting substrate is cleaned by ultrasonic cleaning with pure water and a photoelectric conversion film is formed by p-CVD on the first electrode layer 2 to embed completely the isolation lines 2a. For example, an a-Si:H p-layer, an a-Si:H i-layer (150 nm to 300 nm in thickness) and an a-Si:H n-layer are laminated in this order on the first electrode layer 2 to form the upper semiconductor layer, continuously, a µc-Si:H p-layer, a µc-Si:H i-layer (about 1.5 µm to 3 µm in thickness) and a µc-Si:H n-layer are laminated in this order on the upper semiconductor layer to form the lower semiconductor layer.
Then, the photoelectric conversion film of the tandem structure is partially removed by the light beam to form a contact line 3a, so that the photoelectric conversion layer 3 with a predetermined pattern is formed. In this case, a second harmonic generation (wavelength: 532 nm) of YAG laser is irradiated from the side of the translucent insulation substrate 1 to separate the photoelectric conversion film in a predetermined width in the strip manner, so that the contact line 3a for electrically connecting the first electrode layer 2 and the second electrode layer 4 is formed. Instead of the second harmonic generation of YAG laser, YVO₄ laser (wavelength: 532 nm) can be used.

Then, a conductive film is formed on the photoelectric conversion layer 3 by CVD, sputtering, evaporation or the like to embed completely the contact line 3a. The conductive film and the photoelectric conversion layer 3 are partially removed by the light beam to form isolation lines 7, so that the second electrode layers 4 with a predetermined pattern are formed. Thus, a string of a plurality of thin film photoelectric conversion elements 5 electrically connected in series on the translucent insulation substrate 1 is formed.
In this case, the conductive film may comprise a two-layered structure of a transparent conductive film (ZnO, ITO, SnO₂ or the like) and a metal film (Ag, Al or the like). The thickness of the transparent conductive film may be 10 to 100 nm, while that of the metal film may be 100 to 500 nm.
In patterning the rear electrode layer 4, to avoid the damage of the first electrode layer 2 by the light beam, the second harmonic generation of YAG laser or the second harmonic generation of YVO₄ laser, which can high transparency into the first conductive layer 2, are irradiated from the side of the translucent insulation substrate 1 to separate the conductive film in a predetermined width in the strip manner, so that the isolation lines 7 are formed. It is preferable that processing conditions are selected so as to minimize the damage to the first electrode layer 2 and prevent burr generation of the silver electrode after the second electrode layer 4 is processed.

### [Film removal step]

After the string formation step, the first electrode layer 2, the photoelectric conversion layer 3 and the second electrode layer 4 forming the thin film photoelectric conversion element portion, which are formed on the outer circumference of the surface of the translucent insulation substrate 1, are removed by the fundamental wave of YAG laser in a predetermined width inwardly from the outer circumference end faces of the translucent insulation substrate 1 to form the non-conductive surface region 8 on the entire circumference. Thus, the string S1 surrounded by the non-conductive surface region 8 is formed.
In this case, an insulation separation region 8 is wider than the width of the laser light, so that preferably the width of processing by the laser light is 150 to 1500 µm, and, more preferably, 400 to 1000 µm. To make the processing conditions good, it is preferable that the beam profiles to the processing direction and the processing width direction are distributed close to the rectangular distribution. Thus, the workability can be improved more than the beam profiles of the Gaussian distribution to reduce the overlapping of the beam and the number of the processing lines of the laser, enabling short tact time of the process device.

### [Cleaning step]

As an example of the cleaning step, a wiping member composed of a wiping base member (e.g., a nonwoven fabric) absorbing an organic solvent (e.g., ethanol) is used to wipe the non-conductive surface region 8 positioned on the four-side circumference of the string S1, so that the extraneous matters attached to the non-conductive surface region 8 are wiped to clean up. It is preferable that the amount of absorbing the organic solvent into the wiping base member is such that the organic solvent wet on the non-conductive surface region 8 can be sufficiently volatilized during the time when the thin film solar cell being subject to the preceding steps (after the cleaning step) is transported to the insulation test machine for the next check step.
The cleaning step enables the thin film solar cell to provide the necessary dielectric withstand voltage and improves the adhesion between the non-conductive surface region 8 and the adhesive layer 7, advantageously.

### [Check step]

After the cleaning step, when the thin film solar cell is set in the withstand voltage test machine and a predetermined voltage is applied to the outer circumference end face of the translucent insulation substrate 1 under the condition that a extraction electrode of the second electrode layer 4 is grounded, the passing is determined if the current is a predetermined value (50 µA) or less.
The passing in this check step advances the next step, but the rejection in this check step repeats the cleaning step and the check step once or twice. If the cleaning step and the check step are repeated twice owing to the rejection, then the rejection is still determined, so that the thin film solar cell is rejected as insulation failure and is out from the manufacturing line. A failure portion is detected by a visual inspection or the like to be subjected to a repair step for performing mechanical polishing only to the failure portion.

### [Other steps]

A silver paste 9 is applied on the second electrode layer 4 positioned at the ends in a direction that the cells are connected in series in the thin film solar cell determined to be passing at the check step, and the bus bars 10 are pressed and adhered to the silver paste 9, so that the bus bars 10 are electrically connected to the second electrode layer 4 to make an output portion for outputting the current.
A transparent EVA sheet as the adhesive layer 17 and the rear-side sealing member 18 are laminated on the rear side of the thin film solar cell (the opposed side to the light-receiving side), and the rear-side sealing member 18 is adhered to the thin film solar cell via the adhesive layer 17 with a vacuum laminator to seal the thin film solar cell. It is preferable that a laminated film of PET/Al/PET is used as the rear-side sealing member 18.
Thereafter, the above-mentioned retrieving lines are electrically connected to the output lines in the terminal box, and the terminal box is adhered to the rear-side sealing member 18 to fulfill the terminal box with a silicone resin. Then, an aluminum frame is framed around the outer circumference of the thin film solar cell to finalize manufacturing of the cell.
Thereafter, a predetermined voltage is applied to the aluminum frame under the condition that the second electrode layer 4 is grounded to confirm that the current is a predetermined value or less.

### (Embodiment 2)

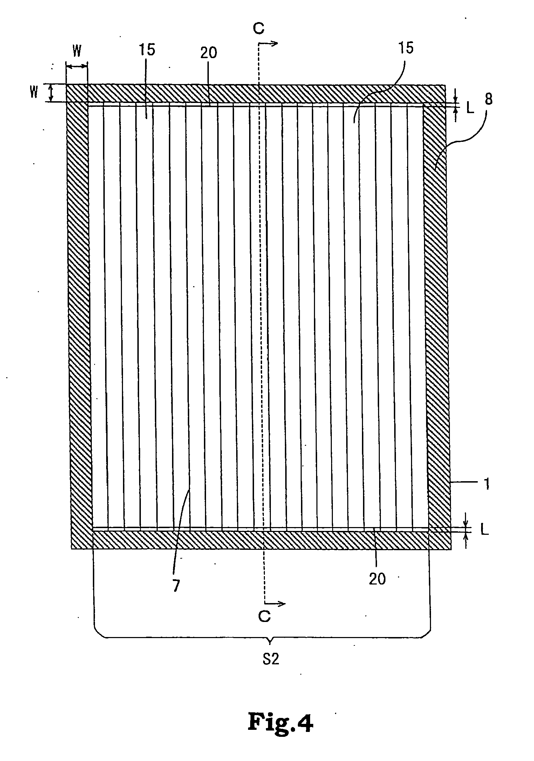

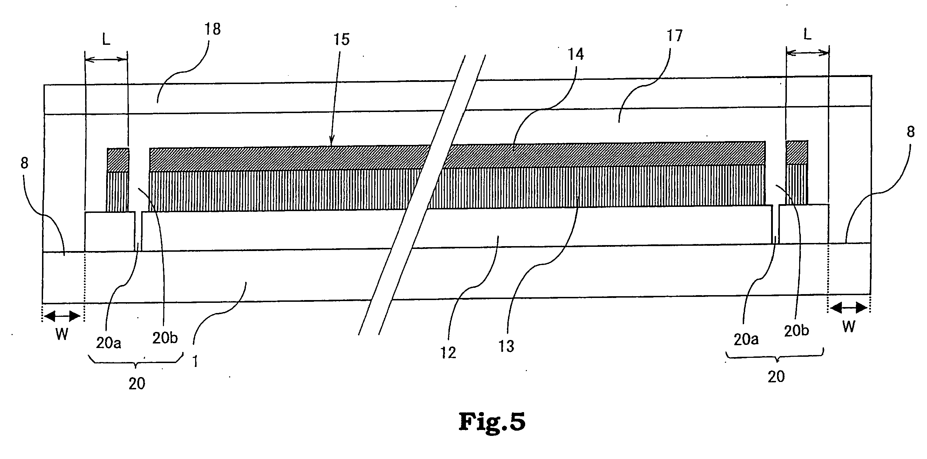

Fig. 4 is a plan view illustrating a thin film solar cell in accordance with an embodiment 2 of the present invention. Fig. 5 is a sectional view taken on line of C-C in Fig. 4. Like elements in Figs. 4 and 5 as those in Figs. 1 and 3 are denoted by like numerals.
The embodiment 2 is different from embodiment 1 in that an insulation separation line 20 of about 100 to 300 µm in width is formed in a distance L inwardly from an interface between the non-conductive surface region 8 and a string S2 which are positioned in a direction (the longitudinal direction of the cells) orthogonal to serial connecting direction of the thin film photoelectric conversion elements 15. The insulation separation line 20 is formed by removing a first electrode layer 12, a photoelectric conversion layer 13 and a second electrode layer 14.
The thin film solar cell of the embodiment 2 is essentially identical with that of the embodiment 1 except that the embodiment 2 has the insulation separation line 20.

It is preferable that the distance L is such that the power generation area of the string S1 remains as broad as possible and the light beam can form the insulation separation line 20 as easily as possible, and specifically is about 0.5 to 10 mm.
The insulation separation line 20 is composed of a first groove 20a of a narrow width (about 30 to 100 µm) formed on the first electrode layer 12 and a second groove 20b of a wide width (about 100 to 300 µm) formed on the photoelectric conversion layer 13 and the second electrode layer 14. The width of the insulation separation line 20 is defined by that of the second groove 20b.
Besides, the distance L is from the interface between the non-conductive surface region 8 and the string S2 to the second groove 20b of the insulation separation line 20.

Thus, the portions of the ends in the orthogonal direction to the series connection direction in the string S1 are separated by providing the insulation separation line 20, so that even in the case where the first electrode layer 12 and the second electrode layer 14 approached to the non-conductive surface region 8 are electrically connected to each other by the conductive extraneous matters, the cell corresponding to these portions can be prevented from not generating the electric power due to short circuit. Although in the embodiment 2 shown in Fig. 4, the cells positioned at the ends in the series connection direction are provided with the insulation separation line 20, it may be unnecessary to form the insulation separation line 20 for the cells positioned at the ends.

The manufacturing method of the embodiment 2 is identical with that of the embodiment 1 except that the film removal step of the embodiment 1 includes the step for forming the insulation separation line 20.
To form the insulation separation line 20, after the first electrode layer 12, the photoelectric conversion layer 13 and the second electrode layers 14 are removed by the fundamental wave of YAG laser to form the first groove 20a, the photoelectric conversion layer 13 and the second electrode layers 14 positioned at the both sides for the first groove 20a are removed by the second harmonic generation to form the second groove 20b. Otherwise, after the photoelectric conversion layer 13 and the second electrode layers 14 are removed by the second harmonic generation to form the second groove 20b, the first electrode layer 12 in the groove 20b is removed by the fundamental wave of YAG laser to form the first groove 20a.
In this case, if the insulation separation line 20 which comprises the first groove 20a and the second groove 20b having the same groove width is formed by the fundamental wave of YAG laser, the problems may occur that the processing dusts of the first electrode layer 12 bridge the first electrode layer 12 and the second electrode layer 14 to cause short circuit or the end face of the photoelectric conversion layer 13 is crystallized by the energy of the laser to increase conductivity so that the first electrode layer 12 and the second electrode layer 14 are short-circuited.
Therefore, according to the embodiment 2, the width of the second groove 20b is wider than that of the first groove 20a to prevent short circuit by differing the groove width from each other. Examples

### (Example 1)

The thin film solar cells having the structure of the embodiment 1 as shown in Figs. 1 to 3 were manufactured by 10000 pieces with the condition corresponding to a system voltage of 1000 V.
A glass substrate of 1.8 mm in thickness and of 560 mm X 925 mm in size was used as the translucent insulation substrate 1. A SnO₂ film of about 800 nm in thickness was deposited on the glass substrate by a thermal CVD method and patterned by the fundamental wave of YAG laser to form the first electrode layer 2.
An obtained substrate was cleaned by ultrasonic cleaning with pure water. Then, an upper semiconductor layer comprising an a-Si:H p-layer, an a-Si:H i-layer (about 200 nm in thickness) and an a-Si:H n-layer was deposited, and a lower semiconductor layer comprising a µc-Si:H p-layer, a µc-Si:H i-layer (about 2 µm in thickness) and a µc-Si:H n-layer was deposited to form a photoelectric conversion film. The photoelectric conversion film was patterned by the second harmonic generation of YAG laser to form the photoelectric conversion layer 3.

Next, after a ZnO film (50 nm in thickness) and an Ag film (125 nm in thickness) were deposited by a magnetron sputtering method, isolation lines 7 were formed by the second harmonic generation of YAG laser to form the second electrode layer 4 with a predetermined pattern.
Then, the first electrode layer 2, the photoelectric conversion layer 3 and the second electrode layer 4 positioned at the outer circumference of the string S1 were removed by the fundamental wave of YAG laser to form the non-conductive surface region 8 of 10 mm in width.
Next, the non-conductive surface region 8 was wiped using a wiping member of a nonwoven fabric dropped with ethanol.
Then, an obtained thin film solar cell was set in the insulation test machine and a voltage of 6000 V was applied to the translucent insulation substrate 1 under the condition that the second electrode layer 4 was grounded to measure a current. The passing percentage that the current was 50 µA or less was determined as to the 10000 pieces of the thin film solar cells of the example 1, and the result was shown in Table 1.

### (Compared example 1)

The thin film solar cells were manufactured by 300 pieces as the compared example 1, being identical with the example 1 except that the non-conductive surface region was not wiped, and then the current for each of them was measured by the same method as the example 1. The passing percentage that the current was 50 µA or less was determined, and the result was also shown in Table 1.

**[Table 1]**

| | Passing Percentage |
|---|---|
| Example 1 | 99.98 % |
| Compared Example 1 | 32.66 % |

Table 1 indicated that the example 1 provided the passing percentage of almost 100 % by cleaning the non-conductive surface region 8 using the wiping member, whereas the compared example 1 omitting the wiping step provided the less passing percentage, remarkably. It was confirmed that the first electrode layer, the photoelectric conversion layer and the second electrode layer removed by the light beam in the film removal step for forming the non-conductive surface region 8 are attached to the non-conductive surface region as the conductive extraneous matters to reduce the dielectric withstand voltage of the thin film solar cell, and that the removal of the extraneous matters by the wiping member was extremely effective though it was simple.

### (Example 2)

The 10000 pieces of the thin film solar cells of the example 1 were framed by an aluminum frame to finalize them. Using the insulation test machine, a voltage of 6000 V was applied to the aluminum frame under the condition that the second electrode layer 4 was grounded, to measure a resistance. When the passing percentage that the current was 50 µA or less was determined as to the 10000 pieces of the thin film solar cells of the example 2, it was 99.98 %.

### (Example 3)

The thin film solar cells having the structure of the embodiment 2 as explained with reference to Figs. 4 and 5 were manufactured by the 1000 pieces based on the example 1. In this time, insulation separation lines 20 of 200 µm in width were formed in a distance of 1 mm inwardly from an interface between the non-conductive surface region 8 and the string S2.
When the 1000 pieces of the thin film solar cells of the example 3 were checked for the insulation test with the same condition as the example 1, the passing percentage was 99.90 %.

### (Example 4)

The 1000 pieces of the thin film solar cells of the example 3 were framed by an aluminum frame to finalize them. When they were checked for the insulation test with the same conditions as the example 2, the passing percentage was 99.90 %.

## Claims

1. A method for manufacturing a thin film solar cell **characterized by** comprising:
a string formation step for forming a string of thin film photoelectric conversion elements which are electrically connected in series and each of which has a first electrode layer, a photoelectric conversion layer and a second electrode layer which are successively laminated on a surface of a translucent insulation substrate;
a film removal step for removing the thin film photoelectric conversion element portion formed on the outer circumference of the surface of the translucent insulation substrate by a light beam to form a non-conductive surface region on the entire circumference; and
a cleaning step for removing conductive extraneous matters generated in the film removal step and attached to the non-conductive surface region.

2. The manufacturing method according to claim 1, wherein the cleaning step is performed by wiping the conductive extraneous matters attached to the non-conductive surface region using a wiping member.

3. The manufacturing method according to claim 1, further comprising a check step for checking an insulation performance of the cleaned non-conductive surface region after the cleaning step.

4. The manufacturing method according to claim 3, wherein in the check step, a predetermined voltage is applied to the outer circumference end face of the translucent insulation substrate under the condition that the second electrode layer is grounded, and the passing is determined if a resistance is a predetermined value or more.

5. The manufacturing method according to claim 4, wherein
when the resistance is less than the predetermined value in the check step, the cleaning step and the check step are repeated in this order once or more.

6. The manufacturing method according to claim 2, wherein the wiping member is a wiping base member consisting of a cloth, a nonwoven fabric or a sponge absorbing an organic solvent.

7. A thin film solar cell manufactured by the manufacturing method according to any one of claims 1 to 6, wherein the thin film solar cell comprises the string formed on the surface of the translucent insulation substrate and the non-conductive surface region formed on the outer circumference of the surface of the translucent insulation substrate, wherein the non-conductive surface region is formed in a predetermined width or more in compliance with a system voltage from the outer circumference end face of the translucent insulation substrate to an inward of a plane direction.

8. The thin film solar cell according to claim 7, further comprising an insulation separation line of 10 to 300 µm in width is formed by removing a thin film photoelectric conversion element portion in a plane direction of 0.5 to 10 mm inwardly from an interface between the non-conductive surface region and the string positioned in a direction orthogonal to serial connecting direction of the thin film photoelectric conversion elements.
